**Europäisches Patentamt**

**European Patent Office**

**Office européen des brevets**

(11) Veröffentlichungsnummer: **0 033 850**
**B1**

# EUROPÄISCHE PATENTSCHRIFT

(12)

(45) Veröffentlichungstag der Patentschrift:
27.07.83

(21) Anmeldenummer: 81100253.4

(22) Anmeldetag: 15.01.81

(51) Int. Cl.³: **H 05 K 7/12, F 16 B 19/00**

(54) Verfahren zum lösbaren Befestigen einer Leiterplatte innerhalb eines Gerätes der Nachrichtentechnik.

(30) Priorität: 30.01.80 DE 3003176

(43) Veröffentlichungstag der Anmeldung:
19.08.81 Patentblatt 81/33

(45) Bekanntmachung des Hinweises auf die Patenterteilung:
27.07.83 Patentblatt 83/30

(84) Benannte Vertragsstaaten:
AT BE CH DE FR GB IT LI LU NL SE

(56) Entgegenhaltungen:
FR-A-2 163 062
FR-A-2 377 110

(73) Patentinhaber: **Licentia Patent-Verwaltungs-GmbH,
Theodor-Stern-Kai 1, D-6000 Frankfurt/Main 70 (DE)**

(72) Erfinder: **Böhm, Lothar, Leipziger Strasse 6,
D-3257 Springe 1 (DE)**

(74) Vertreter: **Einsel, Robert, Dipl.-Ing., Theodor-Stern-Kai 1,
D-6000 Frankfurt/Main 70 (DE)**

## Verfahren zum lösbaren Befestigen einer Leiterplatte innerhalb eines Gerätes der Nachrichtentechnik

Die Erfindung betrifft ein Verfahren zum lösbaren Befestigen einer Leiterplatte innerhalb eines Gerätes der Nachrichtentechnik, insbesondere eines Fernsehempfängers. Bei diesem Verfahren wird die Leiterplatte über durch Öffnungen der Leiterplatte teilweise hindurchragende Köpfe von Haltestiften auf einen Ansatz des Haltestiftes aufgelegt, der die aufgelegte Leiterplatte in definierten Abstand von einer Gehäusewand hält.

Ein derartiges Verfahren ist aus der FR-A-2 377 110 bekannt.

Häufig werden Leiterplatten von einem metallischen Rahmen umgeben, der die Leiterplatte festhält. Dieser Rahmen ist seinerseits lösbar an Stützstellen des Chassis befestigt, so daß die Leiterplatte entweder aus der Halterung der Stützelemente ganz herausgenommen werden kann, oder in eine Servicestellung geklappt werden kann.

Der Rahmen um die Leiterplatten besteht meistens aus einer Metallschiene, die an metallischen Stützpunkten am Chassis befestigt ist. Ein derartiges Verfahren zum Befestigen von Leiterplatten ist relativ aufwendig. Es müssen Schienen hergestellt werden, an denen die Leiterplatten zu befestigen sind. Außerdem sind Stützelemente erforderlich, die am Boden oder am Chassisgestell des Fernsehers befestigt werden müssen. Diese Befestigungselemente haben außerdem ein sehr großes Gewicht.

Eine andere Möglichkeit zur Befestigung von Leiterplatten ist eine Schraubverbindung, durch die die Leiterplatten über Abstandselemente an einem Gehäuseteil des Fernsehers befestigt werden können. Bei der Fertigung eines Fernsehers sind dazu Arbeitsschritte erforderlich, die viel Zeit erfordern. Eine Befestigung von Leiterplatten mittels einer Schnappverbindung ist nur bei sehr kleinen Leiterplatten vorteilhaft anzuwenden, da für eine große Platte eine Vielzahl von Schnappverbindungen vorhanden sein muß, um genügend Haltepunkte zu erhalten. Eine Vielzahl von Schnappverbindungen ist aber gleichzeitig ohne Hilfsmittel nicht zu lösen, so daß im Servicefall Schwierigkeiten beim Lösen einer Leiterplatte entstehen können.

Aus der FR-A-2 377 110 ist ein Verfahren zum Befestigen einer Leiterplatte bekannt, bei dem die Leiterplatte auf durch die Leiterplatten teilweisende hindurchragende mit Ansätzen versehene Haltestifte aufgelegt wird. Die Haltestifte weisen dabei an beiden Seiten unterschiedlich geformte Nasen auf, die federnd ausgebildet sind und nach Durchstecken der Haltestifte die Leiterplatte federnd hintergreifen. Ein Lösen der Haltestifte von der Leiterplatte ist nur durch spezielle Werkzeuge möglich.

Es ist Aufgabe der Erfindung, ein Verfahren zum lösbaren Befestigen einer Leiterplatte innerhalb eines Gerätes der Nachrichtentechnik anzugeben, mit dem auch eine relativ große Leiterplatte einwandfrei gehalten und ohne Schwierigkeiten wieder gelöst werden kann.

Die Aufgabe wird durch die im Anspruch 1 angegebenen Maßnahmen nach der Erfindung gelöst. Weitergehende Merkmale der Erfindung sind in den Unteransprüchen beschrieben.

Die Haltestifte der Leiterplatte sind vorteilhaft so ausgebildet, daß sie gleichzeitig eine Abstützung, eine Einhaltung eines festgelegten Abstandes und eine einwandfreie Halterung einer Leiterplatte ergeben. Durch das Zusammenwirken der Haltestifte mit der Leiterplatte hat die Leiterplatte in nicht arretierten Zustand nur einen Freiheitsgrad der Verschiedemöglichkeiten. Nach Aufsetzen der Rückwand auf den Fernsehempfänger wird die Leiterplatte so arretiert, daß keine Verschiebemöglichkeiten der Leiterplatte mehr bestehen. Die Anordnung der Haltestifte kann beliebig je nach den gestellten Anforderungen gewählt werden. Im Bereich von schwereren Bauteilen auf der Leiterplatte können mehrere Stifte vorgesehen sein, wodurch es möglich wird, auch Bauteile, die bisher eine eigene Befestigung erforderten, auf einer gemeinsamen Leiterplatte unterzubringen.

Die Erfindung wird nachstehend an Hand eines Ausführungsbeispiels näher beschrieben. Es zeigt

Fig. 1 eine Seitenansicht eines Haltestiftes,

Fig. 2 eine Aufsicht auf einen in einer Leiterplatte befindlichen Haltestift,

Fig. 3 eine Anordnung von Haltestift, Leiterplatte und Rückwand im arretierten Zustand.

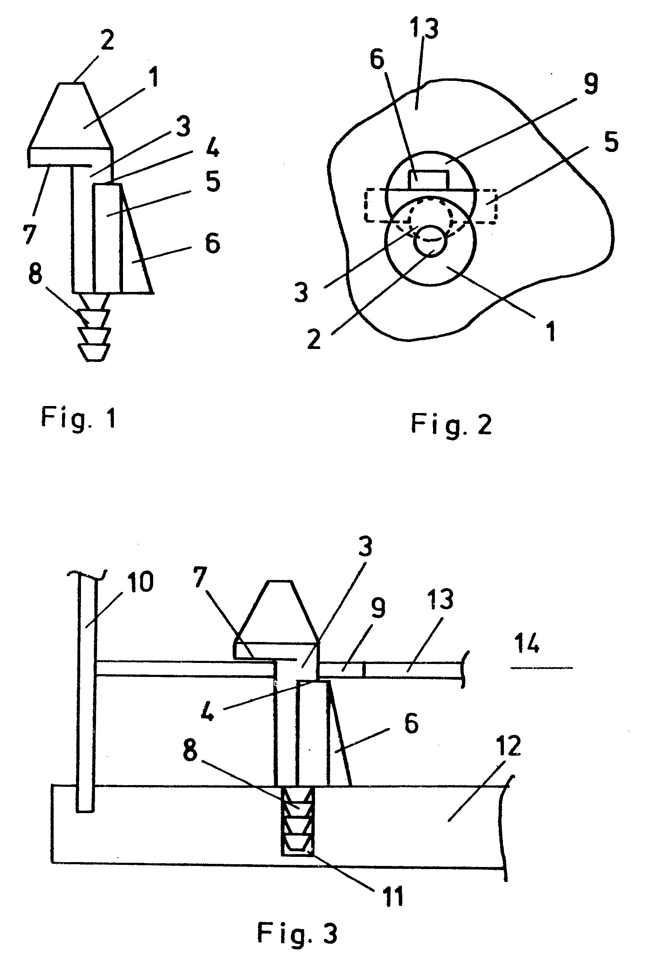

In Fig. 1 ist ein Haltestift dargestellt, der zweckmäßig aus einem Stück aus Kunststoff hergestellt wird. Der Kopf 1 verjüngt sich zur Spitze 2, um eine aufgelegte Leiterplatte besser zentrieren zu können. Die Längsachse des Kopfes 1 steht versetzt zur Längsachse des Halsteiles 3. Das quaderförmige Teil 5 steht seitlich vom Halsteil ab. Zur Befestigung des Haltestiftes in einer Bodenplatte dient ein Fuß 8, der schwalbenschwanzförmig ausgebildet ist. Der Abstand zwischen der Kopfunterseite 7 und der Oberseite 4 des quaderförmigen Teiles 5 ist durch die Dicke einer festzuhaltenden Leiterplatte bestimmt.

Fig. 2 zeigt einen Haltestift in Aufsicht. Durch ein Loch 9 der Leiterplatte 13 ragt der Kopf 1 eines Haltestiftes hindurch, dessen Längsachse versetzt zum Zentrum des Loches 9 verschoben ist. Die Leiterplatte 13 liegt auf dem quaderförmigen Ansatz 5 des Haltestiftes auf, während eine Auslenkung zur dazu entgegengerichteten Seite durch die Unterseite 7 des Kopfes 1 begrenzt ist.

In Fig. 3 ist eine Anordnung dargestellt, in der das Zusammenwirken zwischen Haltestift, Bodenplatte, Leiterplatte und Rückwand ersichtlich ist. Der Haltestift ist mit seinem Fuß 8 in ein Sackloch 11 der Bodenplatte 12 eingesetzt. Durch die mehrfach konusförmige Ausbildung des Fußes 8 ergibt sich bei entsprechender Bemessung des Sackloches 11 ein fester Sitz des Stiftes in der Bodenplatte 12. Der keilförmige Rücken 6 des Haltestiftes ergibt einen zusätzlichen Halt des Haltestiftes gegen seitliche Belastung. Je nach Größe der zu befestigenden Leiterplatte sind eine Reihe von Haltestiften in die Bodenplatte 12 eingelassen. Im Bereich von schweren Bauelementen auf der Leiterplatte sind vorzugsweise mehr Stifte als im Bereich leichterer Bauelemente angeordnet. Den Anordnungen der Haltestifte in der Bodenplatte entsprechend werden die Leiterplatten so vorgestanzt, daß alle Haltestifte gleichzeitig durch Löcher 9 der Leiterplatte 13 hindurchgeführt werden können. Bei allen Haltestiften auf der Leiterplatte 13 ist der Versatz des Kopfes 1 gegenüber dem Halteteil 3 jeweils in Richtung auf die Rückwand gerichtet. Sobald also die Leiterplatte 13 auf der Oberkante 4 des quaderförmigen Ansatzes 5 aller Haltestifte aufliegt, wird diese in Richtung 14 bis zum Anschlag verschoben, so daß nur noch ein Freiheitsgrad entgegengesetzt zur Richtung 14 übrig bleibt. Der obere Anschlag der Leiterplatte ist die Unterkante 7 des Kopfes 1 des Haltestiftes, während der untere Anschlag durch die Oberkante 4 des quaderförmigen Halteelementes 5 gegeben ist. Eine seitliche Verschiebung der Leiterplatte ist ebenso nicht mehr möglich. Nach Auflegen und Verschieben der Leiterplatte 13 wird diese letztendlich durch Anschlag der Rückwand 10 gegen die Leiterplatte 13 fest arretiert.

Das vorgeschlagene Verfahren zum lösbaren Befestigen einer Leiterplatte erfordert keine Halterahmen, ermöglicht eine schnelle und sichere Montage der Halteplatte sowie ein servicefreundliches Lösen der Leiterplatte aus ihrer Verankerung.

**Patentansprüche**

1. Verfahren zum lösbaren Befestigen einer Leiterplatte in einer definierten Lage innerhalb eines Gerätes der Nachrichtentechnik, insbesondere eines Fernsehempfängers, bei dem die Leiterplatte (13) über durch Öffnungen der Leiterplatte (13) teilweise hindurchragende Köpfe (1) von Haltestiften auf einen Ansatz (5) der Haltestifte aufgelegt wird, der die aufgelegte Leiterplatte (13) in definiertem Abstand von einer Gehäusewand hält, dadurch gekennzeichnet, daß die Leiterplatte (13) dann seitlich (in Richtung 14) unter eine vorspringende Unterkante (7) des Kopfes (1) geschoben wird und daß die Leiterplatte (13) schließlich in dem unter der Unterkante des Kopfes (1) befindlichen Zustand durch einen Teil des Gehäuseaufbaus (10) arretiert wird.

2. Verfahren nach Anspruch 1, dadurch gekennzeichnet, daß der Teil des Gehäuseaufbaus die Rückwand (10) des Gerätes ist.

3. Verfahren nach Anspruch 1, dadurch gekennzeichnet, daß im Bereich schwerer Bauelemente auf der Leiterplatte (13) eine größere Zahl von Haltestiften vorgesehen ist, als im Bereich von Bauelementen geringeren Gewichtes.

4. Haltestift für ein Verfahren nach Anspruch 1, dadurch gekennzeichnet, daß er eine Verankerung (8) aufweist, die in ein Loch (11) eines Gehäuseteils (12) einsteckbar ist und daß er einen Anschlag aufweist, der eine definierte Eindringtiefe der Verankerung (8) in das Gehäuseteil bewirkt.

5. Haltestift für ein Verfahren nach Anspruch 1, dadurch gekennzeichnet, daß auf der der von der Arretierung aufgebrachten Andruckkraft abgekehrten Seite des Haltestiftes ein Verstärkungselement (6) zur Erhöhung der Steifigkeit des Haltestiftes vorgesehen ist.

6. Leiterplatte zusammenwirkend mit einem Haltestift nach Anspruch 4 oder 5, dadurch gekennzeichnet, daß die Öffnungen (9) der Leiterplatte (13) kreisförmig ausgebildet sind.

**Claims**

1. Method for releasably securing a circuit board in precise position within a piece of communication equipment, especially a television receiver, in which the circuit board (13) is positioned, by heads (1) on holding posts projecting partly through openings in the circuit board (13), on an extension (5) of the holding posts which holds the positioned circuit board at a precise distance from a wall of the housing, characterized in that, the circuit board is then pushed sideways (in direction 14) under a projecting overhang (7) of the head (1) and that the circuit board (13) is finally restrained by means of a part of the housing structure (10) in the position attained under the overhang.

2. Method according to Claim 1, characterized in that, the part of the housing structure is the back wall (10) of the apparatus.

3. Method according to Claim 1, characterized in that, a larger number of holding posts is provided in the vicinity of heavy components in the circuit board than in the vicinity of components of lesser weight.

4. Holding post for a method according to Claim 1, characterized in that it has a fastening (8) which can be pushed into a hole (11) in a housing part (12) and that it has a rabbet which ensures a precise penetration depth of the fastening (8).

5. Holding post for a method according to Claim 1, characterized in that, on the side of the holding post remote from the pressure induced by the restraining action, a reinforcing element (6) is provided to increase the stiffness of the holding post.

6. Circuit board in co-operative relationship with a holding post according to Claim 4 or 5, characterized in that, the openings (9) of the circuit board are circular.

5      **0 033 850**      6

## Revendications

1. Procédé pour la fixation démontable d'une plaque imprimée dans une position définie à l'intérieur d'un appareil de télécommunication, d'un téléviseur en particulier, et dans lequel la plaque imprimée (13) est munie d'ouvertures, à travers lesquelles passent partiellement les têtes (1) de goujons de fixation et se place sur un épaulement (5) de ces derniers, qui maintient la plaque imprimée (13) posée à une distance définie du boîtier, ledit procédé étant caractérisé en ce que la plaque imprimée (13) est alors glissée latéralement (dans le sens 14) sous un bord inférieur (7) en saillie de la tête (1); puis la plaque imprimée (13) est bloquée sous le bord inférieur de la tête (1) par une pièce de la structure (10) du boîtier.

2. Procédé selon revendication 1, caractérisé en ce que la pièce de la structure du boîtier est la paroi arrière (10) de l'appareil.

3. Procédé selon revendication 1, caractérisé en ce que le nombre de goujons de fixation prévu est plus élevé au voisinage de composants lourds sur la plaque imprimée (qu'au voisinage de composants plus légers).

4. Goujon de fixation pour un procédé selon revendication 1, caractérisé par un ancrage (8) s'insérant dans un trou (11) d'une pièce du boîtier (12), et par une butée qui assure une profondeur définie de pénétration de l'ancrage (8) dans la pièce du boîtier.

5. Goujon de fixation pour un procédé selon revendication 1, caractérisé en ce qu'un élément raidisseur (6) est prévu sur le côté du goujon de fixation opposé à la force d'application produite par le blocage, afin d'augmenter la rigidité du goujon de fixation.

6. Plaque imprimée interagissant avec un goujon de fixation selon revendication 4 ou 5, caractérisée en ce que les ouvertures (9) de la plaque imprimée (13) sont circulaires.

4

Fig. 1

Fig. 2

Fig. 3